Europäisches Patentamt

European Patent Office

Office européen des brevets

(11) Numéro de publication: **0 426 251 A1**

## DEMANDE DE BREVET EUROPEEN

(21) Numéro de dépôt: **90202860.4**

(22) Date de dépôt: **29.10.90**

(51) Int. Cl.⁵: **H01L 21/336**

(30) Priorité: **03.11.89 FR 8914435**

(43) Date de publication de la demande:
**08.05.91 Bulletin 91/19**

(84) Etats contractants désignés:
**DE FR GB IT NL**

(71) Demandeur: **N.V. Philips'
Gloeilampenfabrieken
Groenewoudseweg 1
NL-5621 BA Eindhoven(NL)**

(72) Inventeur: **Verhaar, Robertus
c/o INT. OCTROOIBUREAU B.V. Prof.
Holstlaan 6
NL-5656 AA Eindhoven(NL)**

(74) Mandataire: **Pinchon, Pierre et al
Société Civile S.P.I.D. 156, Boulevard
Haussmann
F-75008 Paris(FR)**

(54) **Procédé pour fabriquer un dispositif à transistors MIS ayant une électrode de grille en forme de "T" inversé.**

(57) Procédé comportant le dépôt d'une première et d'une seconde couche polycristalline conductrice, lesquelles sont séparées par une couche isolante, en vue de créer des îlots de grille s'étendant en direction des portions fortement dopées (22b, 23b) des régions de source et de drain.

Selon l'invention, les îlots de grille (15) sont d'abord délimités dans la première couche polycristalline (12), puis les bords de ces îlots sont protégés par des espaceurs provisoires (20a) en un matériau anti-oxydation, permettant après implantation ionique des portions faiblement dopées (22, 23), de source et de drain, une réoxydation des parties du dispositif non protégées. Après quoi les espaceurs provisoires (20a) sont éliminés et la seconde couche polycristalline (30) est alors déposée, réalisant un contact électrique avec les bords précédemment protégés des îlots (15) de première couche polycristalline (12). Des îlots de grille élargis (35) sont enfin formés en utilisant la technique des espaceurs isolants (32).

Application à la fabrication de dispositifs MIS submicroniques, à haute densité d'intégration.

FIG.5

FIG.8

2

# PROCÉDÉ POUR FABRIQUER UN DISPOSITIF À TRANSISTORS MIS AYANT UNE ÉLECTRODE DE GRILLE EN FORME DE "T" INVERSÉ.

La présente invention concerne un dispositif semiconducteur comportant au moins un transistor de type MIS ayant une région de source et une région de drain comprenant chacune une portion faiblement dopée et une portion fortement dopée légèrement décalée latéralement par rapport à la portion faiblement dopée, ainsi qu'une électrode de grille en forme de T inversé qui recouvre la portionfaiblement dopée et s'étend latéralement vers la portion fortement dopée, procédé qui utilise à partir d'un corps semiconducteur recouvert d'une couche isolante de grille :
- un dépôt d'une première couche polycristalline, rendue conductrice par dopage,
- la formation d'une première couche isolante en vue de son utilisation ultérieure en tant qu'arrêt de décapage,
- un dépôt d'une seconde couche polycristalline conductrice
- une combinaison d'opération consistant à délimiter d'abord des îlots de grille qui servent entreautres de masque pour l'implantation des portions faiblement dopées des régions de source et de drain, puis à former, avec l'une des deux couches polycristallines, des îlots de grille élargis, délimités au pourtour des îlots précédents par des espaceurs isolants formés dans une seconde couche isolante, la partie conservée de seconde couche polycristalline étant en continuité électrique avec la partie conservée de première couche polycristalline,
- puis l'implantation ionique des portions fortement dopées des régions de source et de drain en utilisant ces îlots de grille élargis comme masque d'implantation.

Un transistor MIS à grille débordante (ou grille en forme de T inversé) est connu de la publication "Impact of the Gate-Drain Overlapped Device (GOLD) for Deep Submicrometer VLSI" de R. IZAWA, T. KURE et E. TAKEDA, dans la revue IEEE Transactions on Electron Devices V.35, n°12, décembre 1988.

Un procédé pour fabriquer un transistor de ce type, destiné à la constitution de circuits intégrés à très grande densité d'intégration, est également indiqué dans la même publication.

Les auteurs ont montré que la limitation des performances des transistors MIS de dimensions submicroniques vis-à-vis de la tension de claquage de drain, de l'émission de porteurs chauds, et/ou de la transconductance insuffisante, pouvait être repoussée par l'utilisation d'une électrode de grille recouvrant les portions faiblement dopées des régions de source et de drain, et s'étendant en direction des portions fortement dopées de ces régions, sur une distance qui doit être optimisée.

Le procédé indiqué pour obtenir des transistors MIS de ce type fait usage de deux couches polycristallines, la première de ces couche débordant latéralement des îlots de grille et formant ainsi des îlots dont la forme caractéristique est celle d'un "T" inversé.

Selon le procédé connu, ces deux couches polycristallines sont séparées par une couche d'oxyde excessivemeent mince, soit de l'ordre de 0,5 à 1nm d'épaisseur, de telle sorte que cette couche puisse servir de repère pour l'arrêt de décapage de la deuxième couche polycristalline lors de la formation des îlots de grille, mais assure néanmoins une conduction électrique suffisante entre la première et la deuxième couche polycristalline, au sein de l'îlot de grille élargi du dispositif final.

Un inconvénient inhérent au procédé connu réside dans la difficulté d'obtenir de manière reproductible une couche d'oxyde d'épaisseur aussi faible devant réaliser un compromis très étroit entre l'éfficacité de sa fonction d'arrêt de décapage et une conduction électrique de cette couche assez élevée pour ne pas induire d'effets parasites dans le fonctionnement des transistors et en particulier dans l'efficacité de la transmission des tensions vers la partie inférieure des grilles, dans un large spectre de fréquences.

L'invention propose une modification du procédé connu en vue d'éviter l'inconvénient mentionné. Elle repose sur l'idée que la conduction électrique entre la première et la deuxième couche polycristalline, au sein de l'îlot de grille élargi du dispositif final, pourrait être obtenue par des moyens indépendants de l'épaisseur de la couche dite première couche isolante et qu'ainsi on soit libre de choisir pour cette couche une épaisseur plus substantielle, donc plus aisée à obtenir de manière reproductible et également moins critique à utiliser en tant qu'arrêt de décapage.

En effet, selon la présente invention, un procédé pour fabriquer un dispositif semiconducteur, tel que défini dans le paragraphe introductif, est caractérisé en ce qu'après avoir formé la première couche isolante on réalise successivement :
- la délimitation des îlots de grille par décapages localisés successifs de la première couche isolante et de la première couche polycristalline,
- la formation d'espaceurs provisoires étroits pour la protection des bords des îlots de grille contre l'oxydation par dépôt d'une couche d'un matériau anti-oxydation suivi d'un décapage anisotrope de l'essentiel de cette couche,
- l'implantation ionique des portions faiblement dopées des régions de source et de drain en utilisant
les îlots de grille munis des espaceurs provisoires
en tant que masque d'implantation,
- la réoxydation des parties du dispositif non protégées par les espaceurs provisoires,
- l'enlèvement par décapage sélectif des espaceurs
provisoires,
- le dépôt de la seconde couche polycristalline,
- la formation d'espaceurs isolants réalisés par
dépôt d'une seconde couche isolante suivi par un
décapage anisotrope, de l'essentiel de cette seconde couche isolante,
- la formation d'îlots de grille élargis par décapage
sélectif de l'essentiel de la seconde couche polycristalline, et en utilisant d'une part les espaceurs
isolants comme masque de protection, et d'autre
part la première couche isolante comme arrêt de
décapage,
- l'implantation ionique des portions fortement dopées des régions de source et de drain en utilisant
les îlots de grille élargis comme masque d'implantation, puis,
- les opérations de finition du dispositif relatives
aux prises de contact et aux liaisons électriques
avec les régions actives et les grilles des transistors.

Selon le procédé de l'invention, la continuité
électrique au sein des îlots de grille élargis est
assurée par le contact latéral entre la partie restante de première couche polycristalline et les parties
restantes de la seconde couche polycristalline, en
forme de "L".

Il n'est donc pas nécessaire, comme dans le
cas du procédé connu, de recourir à une première
couche isolante dont l'épaisseur soit suffisamment
mince pour assurer une conduction électrique entre
les deux couches polycristallines qui constituent
l'électrode de la grille du transistor. Dans le procédé selon l'invention, au contraire on utilise avantageusement une première couche isolante dont
l'épaisseur est supérieure à 30nm, ce qui rend le
procédé bien reproductible et simple à mettre en
oeuvre lorsque les première et deuxième couches
isolantes sont réalisées en oxyde de silicium.

Par l'utilisation d'espaceurs provisoires en un
matériau anti-oxydation comme le nitrure de silicium, le procédé selon l'invention permet de procéder à la réoxydation des régions de source et de
drain et notamment les portions qui sont adjacentes au canal du transistor et qui ont pu être endommagées ou subir une pollution lors du décapage
ionique de la première couche polycristalline.

Si on le désire, avant d'effectuer l'étape de
réoxydation, les parties du dispositif non protégées
par les espaceurs provisoires peuvent même être
dénudées des couches isolantes existantes, par décapage sélectif, et ces couches renouvelées ensuite pendant l'étape dite de réoxydation. Les espaceurs provisoires sont faits suffisamment minces
pour que la réoxydation agisse également dans le
sens latéral, sur une courte distance sous lesdits
espaceurs.

Ainsi, selon un mode préféré de mise en oeuvre de l'invention les espaceurs provisoires sont
obtenus à partir d'une couche de nitrure de silicium d'épaisseur comprise entre 15 et 50 nm et de
préférence voisine de 30 nm.

Dans une variante de réalisation, le procédé
selon l'invention est caractérisé en outre par le fait
que des portions additionnelles des régions de
source et de drain, à dopage intermédiaire, sont
réalisées par implantation ionique après le dépôt
de la seconde couche polycristalline et avant la
formation des espaceurs isolants.

Le procédé selon l'invention permet de pratiquer les prises de contact sur le dispositif par
ouvertures de fenêtres de contact localisées au
moyen d'un masque photosensible, selon les techniques habituelles bien connues.

Toutefois, il serait également souhaitable de
pouvoir établir des aires de contact métalliques sur
le dispositif par une technique d'auto-alignement
utilisant entre-autres un siliciure métallique, selon
une technique qui ne nécessiterait pas de masque
pour la réalisation des fenêtre de contact.

Dans ce cas il est possible d'obtenir une réduction sensible des dimensions des transistors et
d'augmenter la densité d'intégration des dispositifs
à nombre très élevé d'éléments.

Cette possibilité est obtenue selon un mode
particulier de mise en oeuvre de l'invention caractérisé en ce qu'après la formation des espaceurs
isolants, l'enlèvement par décapage sélectif de la
seconde couche polycristalline non protégée par
les espaceurs isolants est prolongé d'une durée
déterminée dans des conditions de décapages isotrope, de manière à former des gorges dans les
parties non protégées de la seconde couche polycristalline, et en ce que ces gorges sont ensuite
comblées avec un matériau isolant particulier ayant
des propriétés sélectives de décapage tel que le
nitrure de silicium, par les opérations successives
de dépôt d'une couche d'un tel matériau et de
décapage anisotrope de l'essentiel de cette couche
qui est situé en dehors desdites gorges.

Des fenêtres de contact peuvent alors être
ouvertes sélectivement sur les portions du dispositif qui présentent de l'oxyde de silicium en surface,
tandis qu'en bordure de ces régions subsistent des
cordons dudit matériau isolant particulier qui réalisent un isolement latéral nécessaire entre les plages de contact formées sur les régions actives.

La description qui va suivre en regard des
dessins annexés décrivant des exemples non limitatifs, fera bien comprendre comment l'invention peut être réalisée.

Les figures 1 à 8 montrent des vues schématiques, en coupe, d'une portion de dispositif MIS, illustrant différentes étapes du procédé dans un premier exemple de mise en oeuvre de l'invention,

les figures 9 et 10 présentent des vues schématiques, en coupe, relatives à une variante de mise en oeuvre de l'invention.

Pour plus de clarté des figures, les proportions des dimensions ne sont pas respectées et en particulier certaines dimensions dans le sens de l'épaisseur ont été notablement augmentées. En général, les éléments correspondants sur les différentes figures sont affectés des mêmes signes de référence.

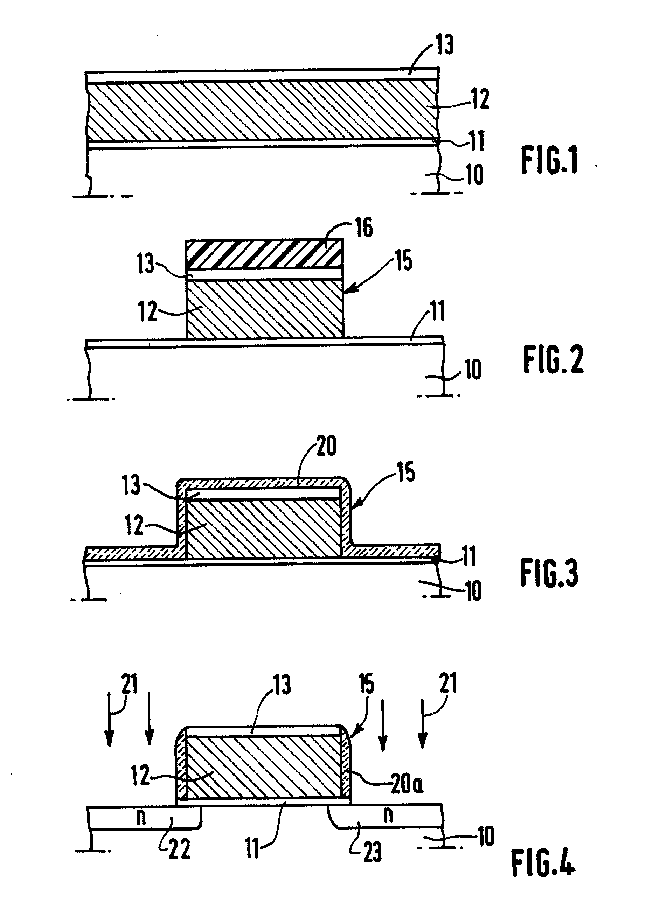

La figure 1 représente une portion superficielle d'un corps semiconducteur 10, par exemple en silicium de type p, qui est surmontée d'une couche isolante de grille 11, de préférence en oxyde de silicium, d'une épaisseur voisine de 20nm. Une première couche polycristalline 12, d'une épaisseur de 300nm environ a été déposée ensuite sur la couche isolante de grille 11. La première couche polycristalline 12 a été rendue conductrice par dopage à une concentration élevée selon l'une des technique habituelle notamment par dopage pendant le dépôt.

A la surface de la première couche polycristalline 12 a été formée ensuite une première couche isolante 13, en oxyde de silicium, d'une épaisseur de 60nm par exemple, qui est destiné à servir ultérieurement d'arrêt de décapage.

Comme indiqué à la figure 2, on réalise ensuite un décapage localisé de la première couche isolante 13 et de la première couche polycristalline 12 de manière à former des îlots de grille 15 selon des techniques de gravure anisotrope connues et en utilisant un masque de résine photosensible 16.

En bref, les îlots de grille 15 peuvent être obtenus en procédant d'abord à un décapage sélectif et localisé de la première couche isolante 13 dans un plasma contenant un mélange d'ions fluor et oxygène, puis en retirant le masque de résine photosensible 16 à l'aide d'un plasma d'oxygène, puis enfin, en décapant sélectivement la première couche polycristalline 12 dans les fenêtres ouvertes précédemment dans la première couche isolante 13, à l'aide d'un plasma contenant principalement des ions de chlore. Ainsi qu'il est connu, le décapage du matériau polycristallin étant sélectif vis-à-vis de l'oxyde de silicium, la couche d'oxyde de grille 11, bien que relativement mince, constitue un arrêt de décapage en fin d'opération.

Après quoi, une couche de protection d'un matériau anti-oxydation 20 comme du nitrure de silicium d'épaisseur comprise entre 15 et 50nm et de préférence voisine de 30nm est déposée par une méthode qui assure une couverture la plus uniforme possible des contours de la surface du dispositif y compris les portions sensiblement verticales des bords des îlots de grille 15. Par exemple, on utilise la méthode connue de dépôt chimique en phase vapeur sous pression réduite (LPCVD).

On décape ensuite l'essentiel de la couche de protection 20 en nitrure de silicium par une méthode de décapage anisotrope par exemple le décapage par ions réactifs de fluor ou de chlore de manière à former des espaceurs provisoires 20a étroits pour la protection des bords des îlots de grille 15 comme cela est indiqué à la figure 4.

Selon le type d'ions de décapage utilisés le décapage du nitrure de silicium n'est pas toujours sélectif vis-à-vis du décapage de l'oxyde de silicium. Le cas échéant, les parties de la couche isolante de grille 11 non protégées qui se situent en dehors des îlots de grille 15 se trouvent éliminées du fait que cette couche isolante est mince. Mais dans tous les cas, au moins une portion subtantielle de la première couche isolante 13 peut être maintenue à la surface supérieure de l'îlot de grille 15 en raison de son épaisseur comparativement importante. On procède ensuite à l'implantation ionique d'un élément dopant de type n, symbolisée par les flèches 21, de manière à former des portions faiblement dopées des régions de source et de drain 22, 23 en utilisant les îlots de grille 15 munis des espaceurs provisoires 20a en tant que masque d'implantation.

A titre d'exemple, cette opération peut être effectuée par implantation de phosphore à une dose de $4.10^{13}$ at/cm$^2$, sous une énergie de 50 à 60 keV.

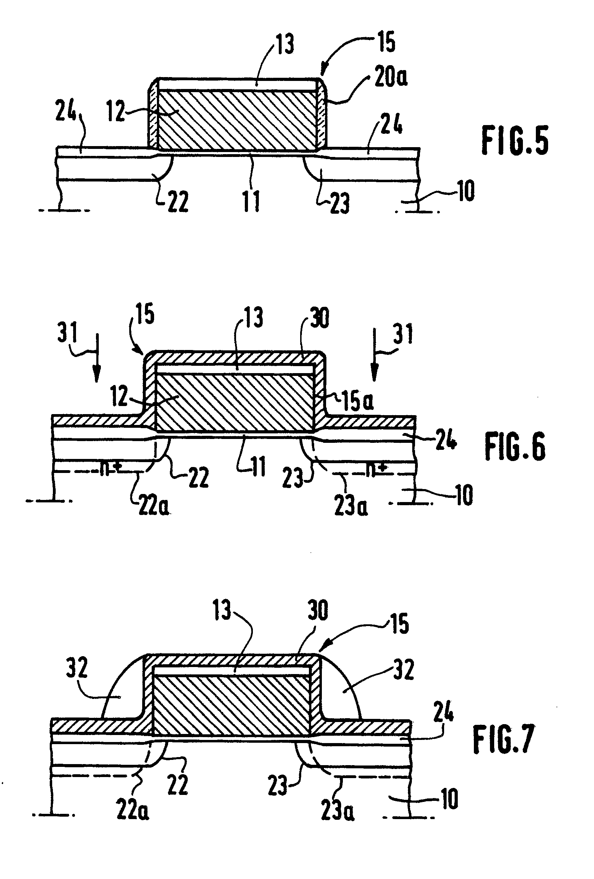

Il résulte des opérations de décapage de la première couche polycristalline 12 et de l'implantation ionique 21 que les extrémités de la couche isolante de grille 11 au bord des îlots de grille 15, et notamment sous les espaceurs provisoires 20a, ont été dégradées et/ou polluées. Pour assurer un bon fonctionnement du dispositif MIS il est donc nécessaire de régénérer les portions de la couche isolante de grille 11 au voisinage de ces extrémités situées sous les espaceurs provisoires 20a ce qui est réalisé, comme indiqué à la figure 5, par une étape de réoxydation des parties du dispositif qui ne sont pas protégées par les espaceurs provisoires 20a. Cette opération est réalisée par exemple par une oxydation thermique à 900°C pendant une durée de 15 à 30 min sous oxygène. La première couche isolante 13 se trouve alors reformée - respectivement régénérée - selon qu'elle était complètement éliminée antérieurement ou conservée sur une portion de son épaisseur. Au dessus des portions dénudées des régions de source et de drain 22, 23 il se forme une couche d'oxyde de silicium 24 d'une épaisseur de l'ordre de 10 à 15nm, tandis que les portions de couche isolante de grille 11 situées sous les espaceurs provisoires 20a et dont l'intégrité a une influence déterminante sur le fonctionnement du dispositif se trouvent régénérées par un effet d'oxydation latérale sous les espaceurs provisoires 20a.

Les étapes qui suivent sont schématisées à la figure 6. On enlève tout d'abord par décapage sélectif les espaceurs provisoires 20a, par exemple par voie humide, dans de l'acide phosphorique chaud (140°C). On dépose ensuite une seconde couche polycristalline 30 d'une épaisseur de 50nm, environ, rendue conductrice par dopage. Cette opération est effectuée de préférence par une méthode assurant une bonne couverture des bords des îlots de grille 15 et par exemple par dépôt chimique en phase vapeur sous pression réduite.

Il est à remarquer que si la seconde couche polycristalline 30 se trouve isolée au-dessus des îlots de grille 15 par la première couche isolante 13, elle se trouve au contraire en contact électrique avec la première couche polycristalline 12 sur les bords 15a des îlots de grille 15, bords qui ont été protégés pendant l'étape de réoxydation par les espaceurs provisoires 20a en nitrure de silicium.

Selon une variante optionnelle du procédé selon l'invention, on peut à ce state pratiquer une implantation ionique symbolisée par les flèches 31 en vue de réaliser des portions additionnelles 22a et 23a des régions de source et de drain, à dopage intermédiaire (n$^+$) permettant d'assurer une variation plus progressive du dopage dans une direction latérale entre le canal et les régions de drain et de source à dopage élevé. Une telle opération d'implantation ionique peut être effectuée par exemple avec du phosphore, à une dose de 2.10$^{14}$ at/cm$^2$ sous une énergie 50 à 70 keV.

Conformément à la figure 7 on réalise ensuite des espaceurs isolants 32 sur les bords des îlots des grille 15 selon une technique connue en soi, qui consiste essentiellement à déposer une seconde couche isolante relativement épaisse de l'ordre de 200nm, en oxyde de silicium, puis à retirer par décapage anisotrope l'essentiel de cette couche, la seconde couche polycristalline 30 formant arrêt de décapage pour cette opération.

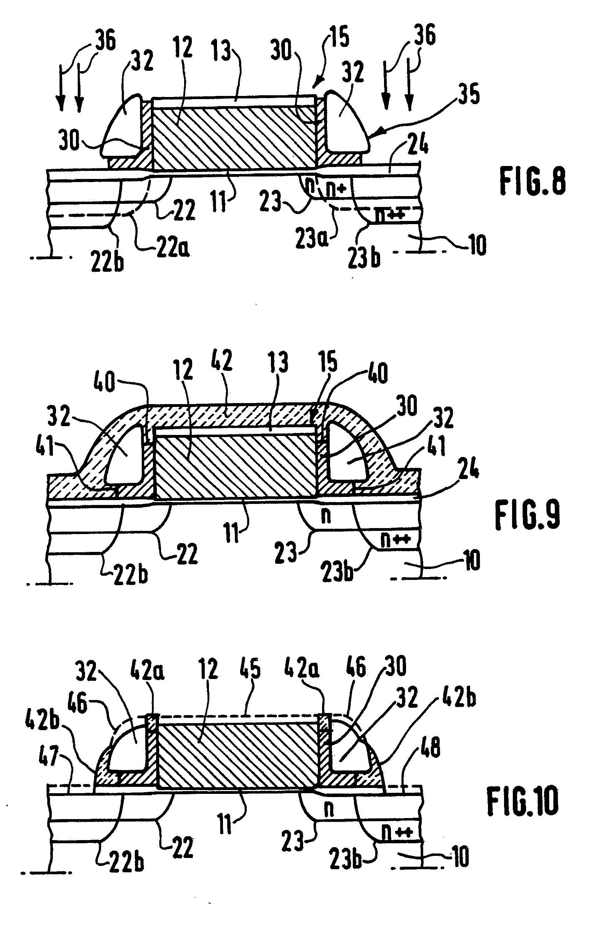

L'opération suivante, figure 8, consiste à retirer l'essentiel de la seconde couche polycristalline 30 c'est-à- dire les portions qui ne sont pas protégées par de l'oxyde de silicium (première couche isolante 13 et espaceurs isolants 32) de manière à former des îlots de grille élargis 35, à partir des îlots de grille 15, dont les dimensions sont augmentées de la largeur des espaceurs isolants 32. Après quoi, on réalise par implantation ionique représentée par les flèches 36 des portions fortement dopées (n$^{++}$) 22b, 23b respectivement, des régions de source et de drain. Ceci peut être fait avec des ions Arsenic, à une dose de 2.10$^{15}$ At/cm$^2$ et sous une énergie de 100 keV.

On notera sur la figure 8 que les portions qui subsistent de la seconde couche polycristalline 30, en forme de L, qui sont en contact électrique avec la portion de première couche polycristalline 12 de l'îlot de grille 15, réalisent avec la première couche polycristalline une électrode de grille en forme de T inversé qui recouvre les portions faiblement dopées 22, 23 des régions de source et de drain ainsi que les éventuelles portions à dopage intermédiaire 22a, 23a. Cette électrode de grille s'étend latéralement vers les portions fortement dopées 22b, 23b des régions de source et de drain.

On notera également que les régions de source et de drain à différent dopage, 22, 23, 22a, 23a, 22b, 23b se présentent d'une manière étagée latéralement dans l'ordre qui convient pour favoriser une tension de claquage élevée de la diode drain/substrat et pour réduire l'émission de porteurs de charge à haute énergie au passage de cette jonction.

A partir de ce stade, le dispositif peut être terminé par ouverture de fenêtres de contact localisée au moyen d'un masque photosensible selon des techniques habituelles bien connues qu'il n'est pas utiles de décrire plus en détail ici.

Les figures 9 et 10 représentent un autre mode de mise en oeuvre de l'invention, permettant de former des aires métalliques de contact sur le dispositif par une technique d'auto-alignement.

Selon ce mode de mise en oeuvre, les étapes du procédé telles qu'elles ont été décrites à propos des figures 1 à 8 sont identiques.

Après la formation des espaceurs isolants 32, l'enlèvement par décapage sélectif de la seconde couche polycristalline 30 qui n'est pas protégée par les espaceurs isolants 32 est prolongé d'une durée déterminée dans des conditions de décapage isotrope de manière à former des gorges 40 de part et d'autre des îlots de grille 15 ainsi que des gorges 41 sous les espaceurs isolants 32 entre ceux-ci et la couche isolante 24. Ces gorges sont réalisées dans la seconde couche polycristalline 30 par décapage latéral dans les parties non protégées de cette couche. On dépose ensuite sur l'ensemble du dispositif une couche d'un matériau isolant ayant des propriétés sélective de décapage, par exemple une couche de nitrure de silicium 42 d'une épaisseur de 100 nm environ par une méthode assurant une bonne couverture de surface par exemple la méthode de dépôt chimique en phase vapeur sous pression réduite, de manière à au moins combler les gorges 40 et 41 avec du nitrure de silicium.

Conformément à la figure 10, la couche de nitrure de silicium 40 est ensuite décapée de manière anisotrope pour ne conserver de cette couche que des portions 42a et 42b, comblant respectivement les gorges 40 et 41. On soumet alors l'ensemble du dispositif à un décapage de l'oxyde de silicium présent en surface, de manière sélective vis-à-vis du nitrure de silicium, ainsi que vis-à-vis du silicium polycristallin et monocristallin. La première couche isolante 13 est complètement retirée de manière à mettre à nu la première couche polycristalline 2 de l'îlot de grille ainsi que les zones de contact 47 et 48 des régions de source et de drain. Le contour de la première couche isolante 13 ainsi que des espaceurs isolants 32 avant cette opération, est indiqué respectivement par les lignes en pointillés 45 et 46. Compte tenu de leur épaisseur importante, la majeure partie des espaceurs isolants 32 est conservée après cette opération.

Ainsi que le montre la figure 10, on peut maintenant former des aires de contact métalliques auto-alignée sur le dispositif étant donné que les zones de surface 47 et 48 de source et de drain ainsi que la partie supérieure des îlots de grille formée essentiellement par la première couche polycristalline 12, sont dénudées et qu'une couche de siliciure métallique peut y être aménagée de manière auto-alignée. Les différentes portions de cette couche de siliciure (non représentée) se trouvent isolées entre-elles, par des portions 42a, 42b de la couche de nitrure de silicium 42 ainsi que par les espaceurs isolants 32.

On obtient à nouveau un dispositif à transistors de type MIS ayant une électrode de grille en forme de T inversé qui recouvre les portions faiblement dopées 22 et 23 des régions de source et de drain et qui s'étend par les portions qui subsistent de la deuxième couche polycristalline 30, en forme de L, vers les portions fortement dopées 22b et 23b des régions de source et de drain. L'extension latérale de cette électrode de grille est contrôlée à l'étape de décapage de la seconde couche polycristalline 30. Aux figures 9 et 10, on n'a pas représenté de portions à dopage intermédiaire des régions de source et de drain telles que celles décrites à la figure 8 dans le premier mode de réalisation de l'invention, mais bien entendu ces portions additionnelles à dopage intermédiaire peuvent également être réalisées dans le mode de mise en oeuvre qui vient d'être décrit.

Le procédé décrit jusqu'ici s'applique à la réalisation de transistors MIS ayant des dimensions très petites. De manière à accroître la densité d'intégration, il peut être nécessaire de prévoir des plots de contact sur les couches de siliciure de source et de drain, qui débordent aussi partiellement sur l'îlot de grille 15 mais sans y faire contact.

Dans ce cas, le contact avec l'îlot de grille 15 est réalisé à un autre emplacement, éloigné du plan de coupe des figures.

Cette disposition (non représentée sur les dessins) peut également être obtenue avec le procédé conforme à l'invention y compris dans sa mise en oeuvre utilisant des aires de contact auto-alignées recouvertes d'un siliciure métallique.

Il suffit pour cela de rendre la première couche isolante 13 nettement plus épaisse à certains emplacements localisés devant être protégés d'un contact métallique.

Cela est aisément obtenu lorsqu'on dépose la première couche isolante 13 en deux étapes : une première étape de dépôt d'une couche de forte épaisseur, par exemple 250nm d'oxyde de silicium, que l'on conserve uniquement aux emplacements à protéger, par décapage localisé, puis une seconde étape de dépôt d'une couche d'oxyde de silicium de 60nm d'épaisseur, recouvrant l'ensemble du dispositif.

En limitant à une valeur convenable la durée de décapage de la première couche isolante 13, à l'étape du procédé précédemment décrite en relation avec la figure 10, il est facile d'obtenir que certaines portions d'îlot de grille 15 restent protégées par de l'oxyde (où la première couche isolante a été prévue plus épaisse) tandis que d'autres portions, non protégées, sont dénudées et donc disponibles pour la prise de contact par siliciure métallique.

**Revendications**

1. Procédé pour fabriquer un dispositif semiconducteur comportant au moins un transistor de type MIS ayant une région de source et une région de drain comprenant chacune une portion faiblement dopée (22, 23) et une portion fortement dopée (22b, 23b) légèrement décalée latéralement par rapport à la portion faiblement dopée, ainsi qu'une électrode de grille (12, 30) en forme de T inversé qui recouvre la portion faiblement dopée et s'étend latéralement vers la portion fortement dopée, procédé qui utilise à partir d'un corps semiconducteur (10) recouvert d'une couche isolante de grille (11) :
- un dépôt d'une première couche polycristalline (12), rendue conductrice par dopage,
- la formation d'une première couche isolante (13) en vue de son utilisation ultérieure en tant qu'arrêt de décapage,
- un dépôt d'une seconde couche polycristalline (30) conductrice,
- une combinaison d'opération consistant à délimiter d'abord des îlots de grille (15) qui servent entre-autres de masque pour l'implantation des portions faiblement dopées (22, 23) des régions de source et de drain, puis à former, avec l'une des deux couches polycristallines, des îlots de grille élargis (35), délimités au pourtour des îlots précédents par des espaceurs isolants (32) formés dans une seconde couche isolante, la partie conservée de seconde couche polycristalline (30) étant en continuité électrique avec la partie conservée de première couche polycristalline (12),

- puis l'implantation ionique des portions fortement dopées (22b, 23b) des régions de source et de drain en utilisant ces îlots de grille élargis (35) comme masque d'implantation caractérisé en ce qu'après avoir formé la première couche isolante (13) on réalise successivement :

- la délimitation des îlots de grille (15) par décapages localisés successifs de la première couche isolante (13) et de la première couche polycristalline (12),

- la formation d'espaceurs provisoires (20a) étroits pour la protection des bords des îlots de grille (15) contre l'oxydation par dépôt d'une couche (20) d'un matériau anti-oxydation suivi d'un décapage anisotrope de l'essentiel de cette couche,

- l'implantation ionique des portions faiblement dopées (22, 23) des régions de source et de drain en utilisant les îlots de grille (15) munis des espaceurs provisoires (20a) en tant que masque d'implantation,

- la réoxydation des parties du dispositif non protégées par les espaceurs provisoires (20a),

- l'enlèvement par décapage sélectif des espaceurs provisoires (20a),

- le dépôt de la seconde couche polycristalline (30),

- la formation d'espaceurs isolants (32) réalisés par dépôt d'une seconde couche isolante suivi par un décapage anisotrope, de l'essentiel de cette seconde couche isolante,

- la formation d'îlots de grille élargis (35) par décapage sélectif de l'essentiel de la seconde couche polycristalline (30), en utilisant d'une part les espaceurs isolants (32) comme masque de protection, et d'autre part la première couche isolante (13) comme arrêt de décapage,

- l'implantation ionique (36) des portions fortement dopées (22b, 23b) des régions de source et de drain en utilisant les îlots de grille élargis (35) comme masque d'implantation, puis,

- les opérations de finition du dispositif relatives aux prises de contact et aux liaisons électriques avec les régions actives et les grilles des transistors.

2. Procédé selon la revendication 1, caractérisé en ce qu'on utilise une première couche isolante (13) dont l'épaisseur est supérieure à 30nm.

3. Procédé selon l'une des revendications 1 ou 2, caractérisé en ce qu'on utilise des espaceurs provisoires (20a) à partir d'une couche (20) de nitrure de silicium d'épaisseur comprise entre 15 et 50nm et de préférence voisine de 30nm.

4. Procédé selon l'une quelconque des revendications 1 à 3, caractérisé en ce que des portions additionnelles (22a, 23a) des régions de source et de drain, à niveau de dopage intermédiaire, sont réalisées par implantation ionique (31) après le dépôt de la seconde couche polycristalline (30) et avant la formation des espaceurs isolants (32).

5. Procédé selon l'une quelconque des revendications 1 à 4, caractérisé en ce qu'après la formation des espaceurs isolants (32), l'enlèvement par décapage sélectif de la seconde couche polycristalline (30) non protégée par les espaceurs isolants est prolongé d'une durée déterminée dans des conditions de décapage isotrope, de manière à former des gorges (40, 41) dans les parties non protégées de la seconde couche polycristalline (30), et en ce que ces gorges sont ensuite comblées avec un matériau isolant particulier ayant des propriétés sélectives de décapage, par les opérations successives de dépôt d'une couche (42) d'un tel matériau et de décapage anisotrope de l'essentiel de cette couche qui est situé en dehors desdites gorges.

6. Procédé selon la revendication 5, caractérisé en ce que ledit matériau isolant particulier est du nitrure de silicium, et en ce que la couche (42) déposée de ce matériau isolant a une épaisseur d'environ 100nm.

FIG.1

FIG.2

FIG.3

FIG.4

FIG.5

FIG.6

FIG.7

FIG.8

FIG.9

FIG.10

**Office européen des brevets**

# RAPPORT DE RECHERCHE EUROPEENNE

Numéro de la demande

## EP 90 20 2860

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | DE-A-3 530 065 (MITSUBISHI)<br>— — — | | H 01<br>L 21/336 |
| A | EP-A-0 173 953 (TOSHIBA)<br>— — — | | |
| A | US-A-4 868 617 (CHIAO et al.)<br>— — — | | |
| D,A | IEEE TRANSACTIONS ON ELECTRON DEVICES, vol. 35, no. 12, décembre 1988, pages 2088-2093, IEEE, New York, US; R. IZAWA et al.: "Impact of the gate-drain overlapped device (GOLD) for deep submicrometer VLSI"<br>— — — — — | | |

**DOMAINES TECHNIQUES RECHERCHES (Int. Cl.5)**

H 01 L

Le présent rapport de recherche a été établi pour toutes les revendications

| Lieu de la recherche | Date d'achèvement de la recherche | Examinateur |
|---|---|---|
| La Haye | 18 décembre 90 | GELEBART Y.C.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire
T : théorie ou principe à la base de l'invention

E : document de brevet antérieur, mais publié à la date de dépôt ou après cette date
D : cité dans la demande
L : cité pour d'autres raisons
........................................................
& : membre de la même famille, document correspondant